# EUROPEAN PATENT APPLICATION

(11) **EP 4 559 774 A1**
(43) Date of publication of application: **28.05.2025**
(21) Application number: 23854709.5
(22) Date of filing: 20.06.2023
(51) Int. Cl.: B61B 13/12, B61B 13/00, B61B 13/06

(54) **TRAVELING VEHICLE SYSTEM**

(30) Priority: 18.08.2022 JP 2022130661
(71) Applicant: Murata Machinery, Ltd., Kyoto-shi, Kyoto 601-8326 (JP)
(72) Inventor: KOBAYASHI, Makoto, Ise-shi, Mie 516-0003 (JP)
(74) Representative: Stöckeler, Ferdinand
(86) International application number: PCT/JP2023/022791
(87) International publication number: WO 2024/038671

(57) **Abstract**

The traveling vehicle system (1) includes a track (4) having a portion that is a non-self-propelling section where the traveling vehicle 6 is unable to be self-propellable, a traveling vehicle (6) configured to travel along the track (4), and a moving unit (60) configured to move the traveling vehicle (6) in one direction in the non-self-propelling section. The moving unit (60) includes a moving mechanism (63) configured to move the movable block (61) in the one direction. The traveling vehicle (6) includes an engagement part (53) capable of being engaged with the movable block (61), and a switching mechanism (53C) configured to switch the position of the engagement part (53) between a first position at which the engagement part (53) is engaged with the movable block (61) and a second position at which the engagement part (53) is separated from the movable block (61). The moving mechanism (63) moves the traveling vehicle (6) by moving the movable block (61) in the one direction with the engagement part (53) engaged.

## Description

### Technical Field

An aspect of the present invention relates to a traveling vehicle system.

### Background Art

An overhead traveling vehicle including a traveling unit capable of traveling along a track is known. In this traveling vehicle, maintenance, such as inspecting and cleaning the traveling unit, needs to be performed periodically. When a part on which maintenance is to be performed is a traveling unit that travels inside the track, the part of the maintenance needs to be exposed from the track. However, because a power feeder configured to supply power to the traveling unit and magnetic plates are disposed on the track, if the track is configured such that the part of the maintenance is exposed as described above, the traveling unit cannot be self-propellable.

For example, Patent Document 1 discloses a traveling vehicle system provided with a moving mechanism configured to move a traveling vehicle along a track. With this traveling vehicle system, the traveling vehicle can be moved along a track where the traveling vehicle cannot be self-propellable.

### Citation List

### Patent Literature

Patent Document 1: International Publication No. WO2020/202856

### Summary of Invention

### Technical Problem

However, the above-described conventional traveling vehicle system has a complicated structure because it includes a mechanism configured to sandwich a traveling unit from front and back so as to fit various sizes of traveling vehicles and a mechanism configured to move the traveling unit in a state in which the traveling unit is sandwiched.

In view of this, it is an object of an aspect of the present invention to provide a traveling vehicle system that can move a traveling vehicle with a simple configuration on a working track where a traveling vehicle cannot be self-propellable.

### Solution to Problem

A traveling vehicle system according to an aspect of the present invention includes: a traveling track forming a self-propelling section where a traveling vehicle is self-propellable; a working track forming a non-self-propelling section where the traveling vehicle is not self-propellable; a traveling vehicle configured to travel along the traveling track; and a moving unit configured to move the traveling vehicle in one direction in the non-self-propelling section. The moving unit includes a moving mechanism configured to move a movable block in the one direction. The traveling vehicle includes one or more engagement parts capable of being engaged with the movable block, and a switching mechanism configured to switch a position of the engagement part between a first position at which the engagement parts are engaged with the movable block and a second position at which the engagement parts are separated from the movable block. The moving mechanism moves the traveling vehicle by moving the movable block in the one direction with the engagement parts engaged.

In the traveling vehicle system thus configured, the movable block and the traveling vehicle can be moved together simply by moving the movable block with which the engagement part included in the traveling vehicle has been engaged. The moving mechanism only needs to move the movable block in the one direction, and the configuration thereof can be simplified. In addition, since the configuration for engaging the engagement part with the moving mechanism is included in the traveling vehicle, the configuration in the moving mechanism can be simplified. In other words, in the traveling vehicle system thus configured, the traveling vehicle can be moved with a simple configuration on a working track where the traveling vehicle cannot be self-propellable.

In the traveling vehicle system according to an aspect of the present invention, the moving mechanism may be a linear motion mechanism including a screw shaft and a driver. With this configuration, the movable block can be moved in the one direction with a simple configuration.

In the traveling vehicle system according to an aspect of the present invention, the engagement parts may be arranged in two or more rows in the one direction at an interval equal to or shorter than a maximum movement distance of the movable block in the linear motion mechanism, and the moving mechanism may engage one of the engagement parts with the movable block to move the traveling vehicle in the one direction and may then engages another of the engagement parts disposed downstream of the one of the engagement parts in the one direction with the movable block to move the traveling vehicle in the one direction. With this configuration, the traveling vehicle can be moved beyond the movable distance of the movable block. This can reduce the size of the moving mechanism in the moving direction of the traveling vehicle.

In the traveling vehicle system according to an aspect of the present invention, the traveling track may include a branching section, and a plurality of guides configured to guide the traveling vehicle in respective directions branching at the branching section, and the engagement parts may be branching rollers configured to switch the traveling direction of the traveling vehicle at the branching section by selectively coming into contact with each of the guides at the branching section. With this configuration, an existing member included in the traveling vehicle can be simply used as the engagement part without providing a new member configured to be engaged with the movable block, and thus the traveling vehicle can be manufactured at low cost.

In the traveling vehicle system according to an aspect of the present invention, the moving mechanism may be supported by a support member attached to the working track. With this configuration, in comparison with a configuration in which the support member is suspended individually from a ceiling or the like, man-hours required for installation can be significantly reduced.

In the traveling vehicle system according to an aspect of the present invention, the working track may be suspended from a trestle installed on a ceiling or a floor of a building, and the traveling vehicle may be an overhead traveling vehicle configured to transport an article by traveling along the working track. With this configuration, the traveling vehicle that a worker working while standing on the floor of the building cannot access can be moved. This is highly effective because it can save time and effort for the worker to prepare a stepladder or the like when manually moving the traveling vehicle.

In the traveling vehicle system according to an aspect of the present invention, the traveling vehicle may include a linear motor configured to travel by magnetic force generated between the linear motor and a magnetic plate provided in the traveling track, and the magnetic plate does not have to be provided in the working track. With this configuration, the traveling vehicle can be moved in a non-self-propelling section where the magnetic plate is not provided. In addition, a top surface portion on which the magnetic plate is provided in the self-propelling section for the traveling vehicle can be made open, and thus maintenance on an upper portion of the traveling unit can be performed easily.

In the traveling vehicle system according to an aspect of the present invention, a power feeder configured to supply electricity to the traveling vehicle may be disposed in the traveling track, and the power feeder does not have to be provided in the working track. With this configuration, the traveling vehicle can be moved in the non-self-propelling section where the power feeder is not provided.

### Advantageous Effects of Invention

According to an aspect of the present invention, on the working track on which the traveling vehicle cannot be self-propellable, the traveling vehicle can be moved with a simple configuration.

### Brief Description of Drawings

[FIG. 1] FIG. 1 is a schematic plan view illustrating a traveling vehicle system according to an embodiment.
[FIG. 2] FIG. 2 is a schematic front view of a traveling vehicle in FIG. 1 when viewed from a traveling direction.
[FIG. 3] FIG. 3 is a perspective view illustrating a working track in FIG. 1.
[FIG. 4] FIG. 4 is a sectional view illustrating the working track in FIG. 3 and a traveling unit of the traveling vehicle.
[FIG. 5] FIGS. 5(A) to 5(E) are diagrams illustrating an example of operation of a moving unit when it moves the traveling vehicle.
[FIG. 6] FIGS. 6(A) to 6(D) are diagrams illustrating another example of the operation of the moving unit when it moves the traveling vehicle.
[FIG. 7] FIGS. 7(A) to 7(C) are diagrams illustrating another example of the operation of the moving unit when it moves the traveling vehicle.

### Description of Embodiments

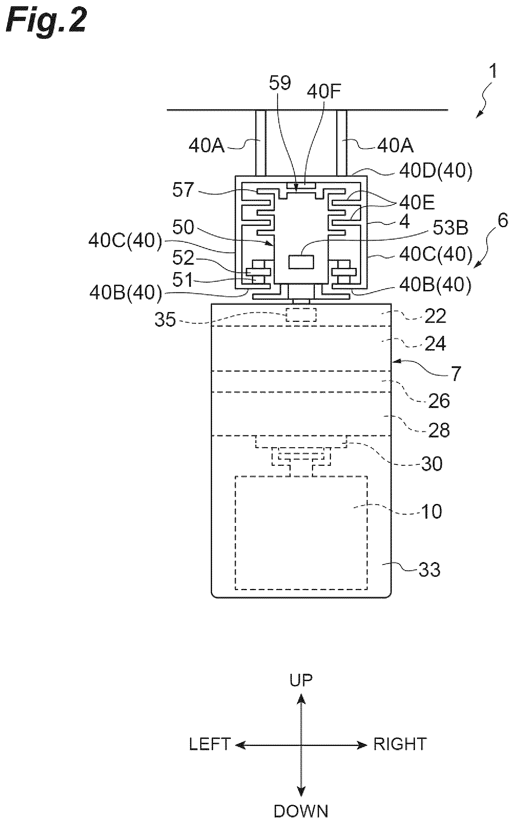

A preferred embodiment according to an aspect of the present invention will be described in detail below with reference to the drawings. In the description of the drawings, identical constituent elements will be denoted by identical reference signs and redundant explanations will be omitted. In FIGS. 2 to 4, the "up", "down", "left", "right", "front", and "back" directions are defined for convenience of explanation.

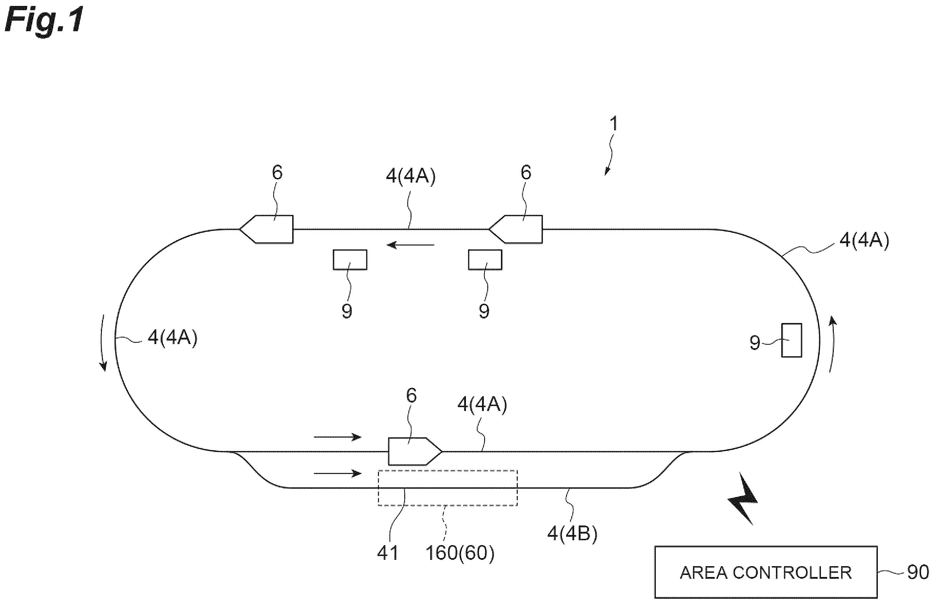

As illustrated in FIGS. 1 and 2, a traveling vehicle system 1 is a system for transporting an article 10 between placement sections 9 and 9 by using an overhead traveling vehicle 6 (hereinafter referred to as traveling vehicle 6) movable along a traveling track 4. Examples of the article 10 include a front opening unified pod (FOUP) storing a plurality of semiconductor wafers, a container storing a glass substrate, a container such as a reticle pod, and common parts. The traveling vehicle system 1 includes the traveling track 4, a plurality of the traveling vehicles 6, a plurality of the placement sections 9, a working track 41, and a moving unit 60.

The traveling track 4 is laid, for example, in the vicinity of a ceiling that is a space above the worker's head. The traveling track 4 is, for example, suspended from the ceiling. The traveling track 4 is a predetermined traveling path for the traveling vehicles 6 to travel. The traveling track 4 is supported by struts 40A and 40A. The traveling track 4 of the traveling vehicle system 1 includes: a main line 4A on which the traveling vehicle 6 travels around a predetermined area in one direction; and a retreat section 4B configured to guide the traveling vehicle 6 to the working track 41 to which a working area 160 for maintenance of the traveling vehicle 6 is provided. In the retreat section 4B also, the traveling vehicle 6 moves in the one direction set in advance.

The traveling track 4 includes: a tubular rail body 40 including a pair of lower surface portions 40B and 40B, a pair of side surface portions 40C and 40C, and a top surface portion 40D; a power feeder 40E; and a magnetic plate 40F. The rail body 40 accommodates (contains) a traveling unit 50 of the traveling vehicle 6. The lower surface portions 40B extend in the traveling direction of the traveling vehicle 6 and form a lower surface of the rail body 40. The lower surface portions 40B are plate-like members to allow traveling rollers 51 of the traveling vehicle 6 to roll. The side surface portions 40C extend in the traveling direction of the traveling vehicle 6 and form side surfaces of the rail body 40. The top surface portion 40D extends in the traveling direction of the traveling vehicle 6 and forms an upper surface of the rail body 40.

The power feeder 40E is a part configured to supply electricity to power feed cores 57 of the traveling vehicle 6 and transmit and receive a signal to and from the power feed cores 57. The power feeder 40E is fixed to each of the pair of side surface portions 40C and 40C and extends along the traveling direction. The power feeder 40E supplies electricity to the power feed cores 57 in a contactless manner. The magnetic plate 40F causes a linear DC motor (LDM) 59 of the traveling vehicle 6 to produce magnetic force for traveling or stopping. The magnetic plate 40F is fixed to the top surface portion 40D and extends along the traveling direction.

The traveling vehicle 6 travels along the traveling track 4 and transports the article 10. The wording "the traveling vehicle 6 travels on the traveling track 4" means that the traveling rollers 51 of the traveling vehicle 6 roll on the lower surface portions 40B of the traveling track 4. The traveling vehicle 6 is configured to be able to transfer the article 10. The traveling vehicle 6 is an automated overhead traveling vehicle. The number of traveling vehicles 6 included in the traveling vehicle system 1 is not particularly limited and is more than one. Each traveling vehicle 6 includes a main body 7, a traveling unit 50, and a traveling vehicle controller 35. The main body 7 includes a body frame 22, a lateral feed unit 24, a θ drive 26, an elevation driver 28, an elevation stage 30, and a cover 33.

The body frame 22 is connected to the traveling unit 50 and supports the lateral feed unit 24, the θ drive 26, the elevation driver 28, the elevation stage 30, and the covers 33. The lateral feed unit 24 laterally feeds the θ drive 26, the elevation driver 28, and the elevation stage 30 collectively in a direction perpendicular to the traveling direction of the traveling track 4. The θ drive 26 turns at least one of the elevation driver 28 and the elevation stage 30 within a predetermined angle range in a horizontal plane. The elevation driver 28 elevates and lowers the elevation stage 30 by reeling or unreeling a suspension member such as a wire, a rope, and a belt. The elevation stage 30 has a chuck and can grip or release the article 10. A pair of the covers 33 are provided, for example, on the front and the back of the traveling vehicle 6 in the traveling direction. The covers 33 extend and retract not-illustrated claws or the like and prevent the article 10 from dropping during transportation.

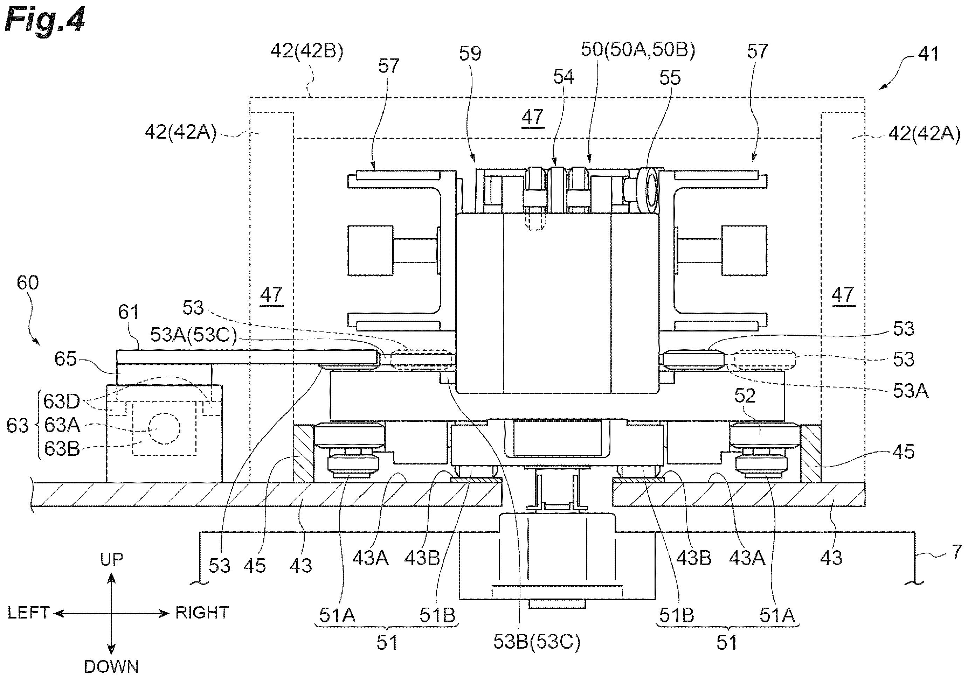

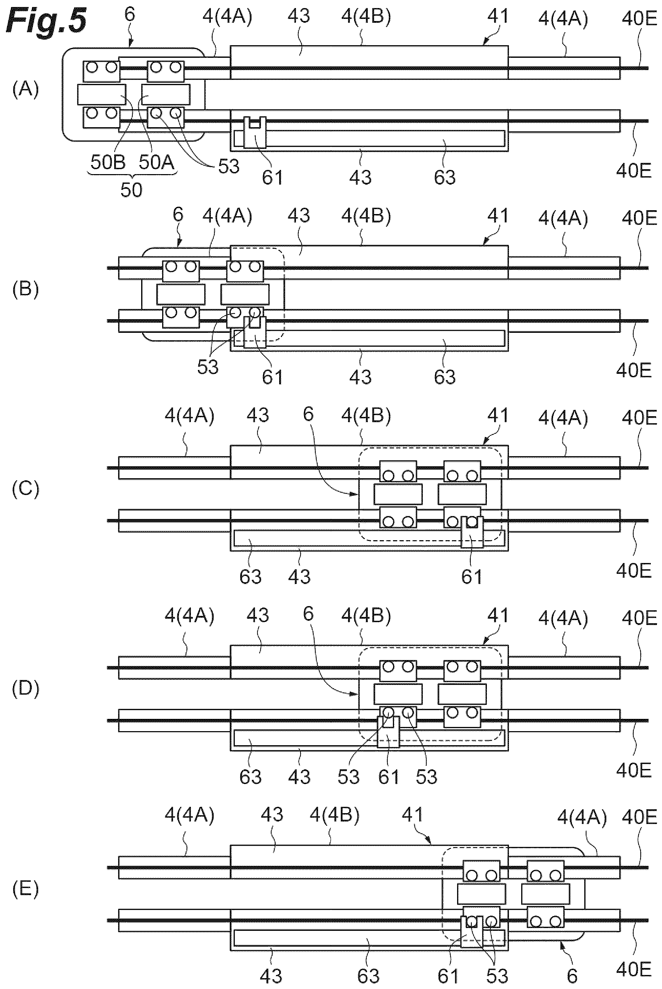

The traveling unit 50 allows the traveling vehicle 6 to travel along the traveling track 4. The traveling unit 50 includes two bodies 50A and 50B as illustrated in FIGS. 5(A) to 5(E), and the two bodies 50A and 50B are connected to each other. Each of the two bodies 50A and 50B of the traveling unit 50 includes traveling rollers 51, side rollers 52, branching rollers (engagement parts) 53, auxiliary rollers 54, slanted rollers 55, power feed cores 57, and the LDM 59, as illustrated in FIG. 4. In FIG. 2, the branching rollers 53, the auxiliary rollers 54, and the slanted roller 55 are not illustrated.

The traveling rollers 51 are a pair of rollers each including an outer wheel 51A as a traveling wheel and an inner wheel 51B as a traveling auxiliary wheel. The traveling rollers 51 are disposed on the left and right ends at the front and the back of the traveling unit 50. The traveling rollers 51 roll on the pair of lower surface portions 40B, 40B (or lower support portions 43 in FIG. 4 described later) of the traveling track 4. The side rollers 52 are disposed to sandwich each of the outer wheels 51A of the traveling rollers 51 in the front-back direction. The side rollers 52 are provided so as to be able to come into contact with the side surface portions 40C of the traveling track 4 (or side support portions 45 in FIG. 4 described later).

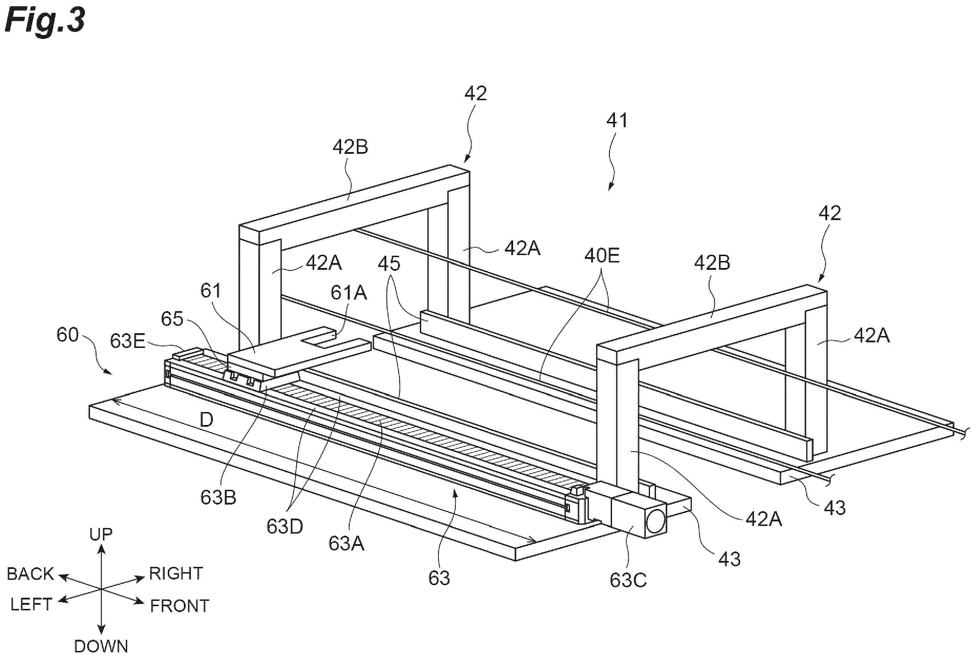

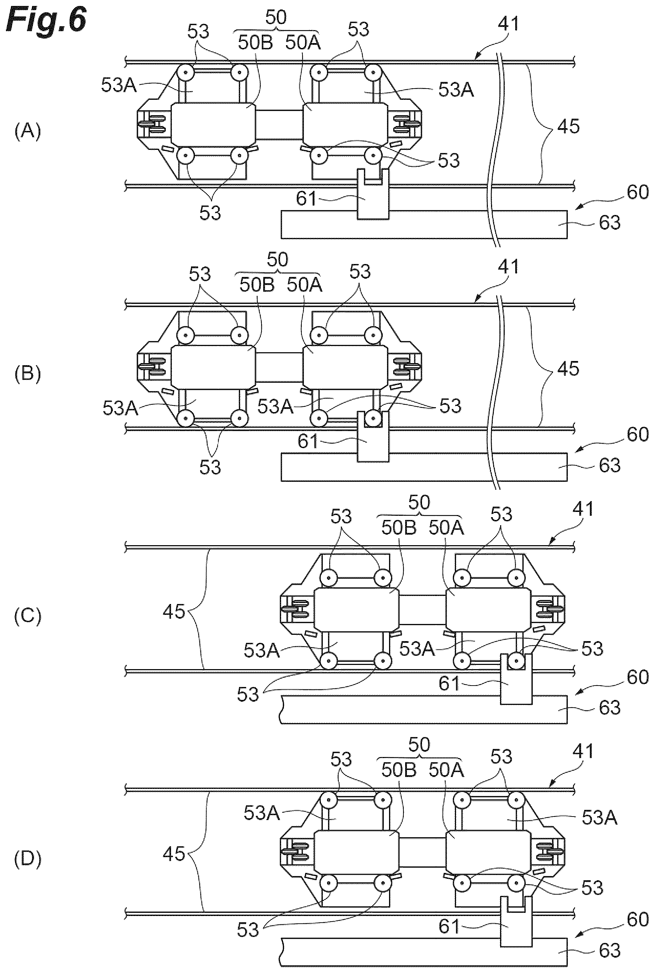

The branching rollers 53 are provided to switch the traveling vehicle 6 (traveling unit 50) to travel straight ahead or branch off at a branching section of the traveling track 4. More specifically, the branching rollers 53 are selectively brought (caused to come) into contact with a guide member provided at the branching section to be guided, whereby the traveling direction of the traveling vehicle 6 is switched. Four branching rollers 53 are provided for one body 50A (50B) (see FIGS. 6(A) to 6(D)). The branching rollers 53 are arranged in two or more rows in the traveling direction (one direction) of the traveling vehicle 6 at an interval equal to or shorter than a maximum movement distance D (see FIG. 3) of the movable block 61 in the moving mechanism 63. In the present embodiment, four of them are arranged on the left side of the traveling vehicle 6 along the traveling direction, and four of them are arranged on the right side of the traveling vehicle 6 along the traveling direction. The branching rollers 53 that can be engaged with the movable block 61 are the four branching rollers 53 arranged on the left side of the traveling vehicle 6.

The branching rollers 53 are provided to be movable in the left-right direction by a switching mechanism 53C. The position of the branching rollers 53 is switched between a first position (see FIG. 6(B)) at which they are engaged with the movable block 61 described later in detail and a second position (see FIG. 6(A)) at which they are separated from the movable block 61. Each of the bodies 50A and 50B is provided with the switching mechanism 53C. Each of the switching mechanisms 53C includes a support member 53A and a roller driver 53B. The support member 53A supports the four branching rollers 53 and is provided to be movable in the left-right direction (width direction). The roller driver 53B moves the support member 53A in the left-right direction. The switching mechanism 53C moves the four branching rollers 53 together in the left-right direction by moving the support member 53A in the left-right direction. The driving of the roller driver 53B is controlled by the traveling vehicle controller 35 that has received a command from an area controller 90.

The auxiliary rollers 54 constitute groups, each including a set of three rollers, provided at the front and the back of the traveling unit 50. The auxiliary rollers 54 are provided to prevent the LDMs 59, the power feed cores 57, and the like from coming into contact with the magnetic plate 40F disposed on the upper surface of the traveling track 4 when the traveling unit 50 tilts back and forth during traveling due to, for example, acceleration/deceleration. The slanted rollers 55 are provided at four corners of the LDMs 59. The slanted rollers 55 are disposed in a manner slanted from the front-back direction. The slanted rollers 55 are provided to prevent tilting due to centrifugal force when the traveling unit 50 travels at a curve section.

The power feed cores 57 are disposed at the front and the back of the traveling unit 50 so as to sandwich the LDM 59 in the left-right direction. Contactless power feeding and contactless transmission/reception of a variety of signals are performed between each power feed core 57 and the corresponding power feeder 40E disposed at the traveling track 4 and the working track 41. The power feed cores 57 exchange a signal with the traveling vehicle controller 35. The LDMs 59 are provided at the front and the back of the traveling unit 50. Each LDM 59 uses an electromagnet to produce magnetic force for traveling or stopping between the LDM 59 and the magnetic plate 40F disposed on the upper surface of the traveling track 4.

As illustrated in FIG. 1, the placement sections 9 are arranged along the traveling track 4 and provided at positions where the article 10 can be delivered to and from the traveling vehicle 6. The placement sections 9 each include a buffer and a delivery port. The buffer is a placement section on which the article 10 is temporarily placed. The buffer is a placement section on which the article 10 is temporarily placed when the article 10 transported by the traveling vehicle 6 cannot be transferred to a target delivery port, for example, for the reason that another article 10 has been placed on the target delivery port. The delivery port is, for example, a placement section for delivering the article 10 to and from a semiconductor processing device (not illustrated) such as a cleaning device, a deposition device, a lithography device, an etching device, a thermal treatment device, and a planarization device. The processing device is not limited to a specific device and may be a variety of devices.

For example, the placement sections 9 are arranged to the side of the traveling track 4. In this case, the traveling vehicle 6 delivers an article 10 to and from a placement section 9 by causing the lateral feed unit 24 to laterally feed the elevation driver 28 or the like and by slightly elevating and lowering the elevation stage 30. Although not illustrated, the placement sections 9 may be arranged immediately below the traveling track 4. In this case, the traveling vehicle 6 delivers the article 10 to and from the placement section 9 by elevating and lowering the elevation stage 30.

The traveling vehicle controller 35 is an electronic control unit including a central processing unit (CPU), a read only memory (ROM), and a random access memory (RAM). The traveling vehicle controller 35 controls various operations in the traveling vehicle 6. Specifically, the traveling vehicle controller 35 controls the traveling unit 50, the lateral feed unit 24, the θ drive 26, the elevation driver 28, the elevation stage 30, and the roller driver 53B. The traveling vehicle controller 35 can be configured, for example, as software that is a program stored in the ROM, loaded into the RAM, and executed by the CPU. The traveling vehicle controller 35 may be configured as hardware with electronic circuitry, for example. The traveling vehicle controller 35 communicates with the area controller 90, using the power feeder 40E such as feeder lines provided in the traveling track 4.

The area controller 90 is an electronic control unit including a CPU, a ROM, a RAM, and the like. The area controller 90 can be configured, for example, as software that is a program stored in the ROM, loaded into the RAM, and executed by the CPU. The area controller 90 may be configured as hardware with, for example, electronic circuitry. The area controller 90 transmits a transportation command to the traveling vehicle 6 to transport the article 10.

As illustrated in FIG. 1, the working area 160 is an area that is provided in a part of the retreat section 4B and in which maintenance of the traveling rollers 51, the power feed cores 57, and the like of the traveling unit 50 included in the traveling vehicle 6 is performed. In the working area 160, the working track 41 (see FIG. 3) and the moving unit 60 (see FIGS. 5 and 6) are provided.

The working track 41 extends in one direction (hereinafter referred to as "extending direction") such that both ends thereof are continuous to the traveling tracks 4 and 4 and, as illustrated in FIGS. 3 and 4, forms openings 47 to expose at least a portion (e.g., the power feed cores 57) of the traveling unit 50. In other words, in the working track 41, the side surface portions 40C and the top surface portion 40D included in the traveling track 4 are not provided, and the magnetic plate 40F provided on the top surface portion 40D is not provided either. Thus, the traveling vehicle 6 cannot be self-propellable on the working track 41. In the traveling track 4, the working track 41 forms a non-self-propelling section where the traveling vehicle 6 cannot be self-propellable. It can be said that the traveling track 4 forms an self-propelling section where the traveling vehicle 6 can be self-propellable.

The working track 41 includes frames 42 disposed at both ends of the working track 41, a pair of the lower support portions 43 and 43, a pair of the side support portions 45 and 45, and the power feeders 40E.

Each frame 42 includes a pair of pillars 42A and 42A and a horizontal portion 42B. The pair of pillars 42A and 42A are columnar members disposed to be opposed to each other in the left-right direction and extending in the vertical direction. The horizontal portion 42B is fixed to the ceiling with a bracket (not illustrated) and a strut (not illustrated) interposed therebetween. The horizontal portion 42B is a columnar member connecting the pair of pillars 42A and 42A at the upper ends of the pair of pillars 42A and 42A.

The lower support portions 43 support the traveling unit 50 from below. More specifically, the lower support portions 43 are members on which the inner wheels 51B of the traveling rollers 51 of the traveling vehicle 6 roll and travel. The lower support portions 43 are fixed to the lower ends of the pillars 42A of the frame 42. The lower support portions 43 are formed such that first portions 43B facing the inner wheels 51B are positioned above second portions 43A facing the outer wheels 51A in the vertical direction. The first portions 43B of the lower support portions 43 (i.e., the rolling surfaces of the inner wheels 51B) are connected to the traveling track 4 so as to form planes on the same level as (be flush with) the upper surfaces of the lower surface portions 40B (see FIG. 2) of the traveling track 4 at locations connected thereto. The side support portions 45 are members with which the side rollers 52 of the traveling vehicle 6 are in contact.

The side support portions 45 are laid over between the pair of frames 42 and 42. The power feeders 40E are laid over between the pair of frames 42 and 42 and are disposed in the openings 47 on the sides of the working track 41. The power feeders 40E provided in the working track 41 are connected to the power feeders 40E provided in the traveling track 4. In other words, on the working track 41, the traveling vehicle 6 cannot be self-propellable but can receive supply of electricity.

As illustrated in FIGS. 3 to 5, the moving unit 60 moves the traveling vehicle 6 along the extending direction (one direction) of the working track 41 that is a non-self-propelling section. To both ends of the working track 41, the traveling tracks 4 and 4 are connected. The moving unit 60 moves the traveling vehicle 6, which cannot be self-propellable, from one traveling track 4 to the other traveling track 4. The moving unit 60 includes a movable block 61 and a moving mechanism 63.

The movable block 61 is a member with which a branching roller 53 can be engaged. More specifically, the movable block 61 has a recess 61a into which the branching roller 53 can enter (engage). The moving unit 60 moves the movable block 61 with the branching roller 53 engaged in the recess 61a, thereby moving the branching roller 53 and consequently the traveling unit 50 together with the movable block 61.

The moving mechanism 63 is a mechanism configured to move the movable block 61 in the extending direction of the working track 41. The moving mechanism 63 is a linear motion mechanism (ball screw) including a screw shaft 63A, a nut 63B, a shaft driver 63C, and slide rails 63D. The screw shaft 63A is a long member having a thread groove formed on its outer circumference and extending in one direction, one end portion thereof is connected to the shaft driver 63C and the other end portion is supported by a bearing 63E. The screw shaft 63A is disposed such that the extending direction thereof is substantially parallel to the extending direction of the working track 41.

The nut 63B is a member that is screwed into the thread groove of the screw shaft 63A. The nut 63B moves along the extending direction of the screw shaft 63A, that is, the extending direction of the working track 41, as the screw shaft 63A is rotated. The nut 63B is supported so as to be slidable on the slide rails 63D. The shaft driver 63C is a motor, and the rotating shaft thereof is connected to the screw shaft 63A. The driving of the shaft driver 63C is controlled by the area controller 90. The slide rails 63D support a portion of the nut 63B from below slidably along the extending direction of working track 41.

The moving mechanism 63 is disposed on one of the pair of lower support portions 43 and 43, and is disposed in a manner supported from below by the lower support portion (support member) 43 on the left. In the present embodiment, an example has been described in which the moving mechanism 63 is disposed in a part of the lower support portions 43 supporting the traveling vehicle 6 from below. However, for example, a support member specifically for supporting the moving mechanism 63 may be attached to the pair of frames 42 and 42, for example, and the moving mechanism 63 may be supported by this support member. The lower support portion 43, to which the moving mechanism 63 is provided, may be provided with a cleaning device configured to clean the traveling vehicle 6 and maintenance equipment such as a camera for inspecting various parts of the traveling vehicle 6.

The following describes operation of the moving unit 60 when it moves the traveling vehicle 6 mainly with reference to FIGS. 5 and 6. As illustrated in FIGS. 5(A) and 5(B), the traveling vehicle 6 arrives at the working track 41 in response to a command, from the area controller 90, to move to the working area 160 (working track 41). As described above, the magnetic plate 40F is not provided in the working track 41, but the traveling vehicle 6 can travel if at least a part of one of the two bodies 50A and 50B is in a position where it overlaps the magnetic plate 40F of the traveling track 4. As illustrated in FIG. 6(A), the traveling vehicle 6 stops in a state in which, for example, one body 50A has entered the working track 41.

The movable block 61 is waiting at a position on the side of the traveling vehicle 6 that has stopped in the state in which one body 50A has entered the working track 41. More specifically, the movable block 61 is waiting at the side of a branching roller 53 in the front row of the traveling vehicle 6. In this state, as illustrated in FIG. 6(B), the traveling vehicle 6 drives the roller driver 53B of each switching mechanism 53C to move the corresponding support member 53A to the left. In other words, the position of the branching roller 53 is switched from the second position at which the branching roller 53 is separated from the movable block 61 to the first position at which the branching roller 53 is engaged with the movable block 61. Consequently, the branching roller 53 is engaged with the movable block 61.

The moving mechanism 63 moves the movable block 61, with which the branching roller 53 included in the traveling vehicle 6 has been engaged, in the extending direction of the working track 41 (one direction), thereby moving the traveling vehicle 6 together. The moving mechanism 63 moves them to, for example, a predetermined position of the working track 41. The maintenance equipment described above is provided at the predetermined position, and predetermined maintenance is performed on the traveling vehicle 6. The moving mechanism 63 then moves the movable block 61 to an end portion of the moving mechanism 63 in the extending direction as illustrated in FIG. 5(C).

In this state, as illustrated in FIG. 6(C), the traveling vehicle 6 drives the roller driver 53B of the switching mechanism 53C to move the support member 53A to the right. In other words, the position of the branching roller 53 is switched from the first position to the second position. Consequently, the branching roller 53 is separated from the movable block 61 as illustrated in FIG. 6(D). The moving mechanism 63 then moves the movable block 61 in the direction opposite to the moving direction of the traveling vehicle 6 and stops it on the side of a branching roller 53 disposed at the backmost row of the traveling vehicle 6, as illustrated in FIG. 5(D).

Subsequently, in the same manner as described above, the traveling vehicle 6 drives the roller driver 53B of the switching mechanism 53C to move the support member 53A to the left such that the branching roller 53 is engaged with the movable block 61. The moving mechanism 63 then moves the traveling vehicle 6 until, for example, one body 50A has entered the traveling track 4 as illustrated in FIG. 5(E). Thus, the moving mechanism 63 of the present embodiment engages the branching roller 53 (one of the engagement parts) disposed in the front row of the traveling vehicle 6 with the movable block 61 to move the traveling vehicle 6 in the extending direction of the working track 41, and then engages the branching roller 53 disposed in the backmost row of the traveling vehicle 6 (engagement part disposed downstream of the one engagement part in the one direction) with the movable block 61 to move the traveling vehicle 6 in the one direction.

In the position of the traveling vehicle 6 illustrated in FIG. 5(E), the traveling vehicle 6 drives the roller driver 53B of the switching mechanism 53C to move the support member 53A to the right. In other words, the position of the branching roller 53 is switched from the first position to the second position. Consequently, the branching roller 53 is separated from the movable block 61. As described above, in this state, the traveling vehicle 6 can be self-propellable because the body 50A of the two bodies 50A and 50B has advanced to a position where it overlaps the magnetic plate 40F of the traveling track 4. The traveling vehicle 6 leaves the working area 160 in response to a move command from the area controller 90.

The operation and effect of the traveling vehicle system 1 in the above-described embodiment will now be described. In the traveling vehicle system 1 of the above embodiment, the movable block 61 and the traveling vehicle 6 can be moved together simply by moving the movable block 61 with which the branching roller 53 included in the traveling vehicle 6 has been engaged. The moving mechanism 63 only needs to move the movable block 61 in the one direction, and thus the configuration thereof can be simplified. In addition, since the configuration for engaging the branching roller 53 with the movable block 61 is included in the traveling vehicle 6, the configuration in the moving mechanism 63 can be simplified.

In the traveling vehicle system 1 of the above embodiment, the moving mechanism 63 is a linear motion mechanism (ball screw) including the screw shaft 63A and the shaft driver 63C, and thus the movable block 61 can be moved in the extending direction of the working track 41 with a simple configuration.

In the traveling vehicle system 1 of the above embodiment, the branching roller 53 is arranged in two or more rows in the traveling direction of the traveling vehicle 6 at an interval equal to or shorter than a the maximum travel distance D of the movable block 61 in the linear motion mechanism, and the moving mechanism 63 engages a branching roller 53 in the front row with the movable block 61 to move the traveling vehicle 6 in the extending direction of the working track 41, and then engages a branching roller 53 in the backmost row with the movable block 61 to move the traveling vehicle 6 in the extending direction of the working track 41. With this configuration, the traveling vehicle 6 can be moved beyond the movable distance of the movable block 61. This can reduce the size of the moving mechanism 63 in the moving direction of the traveling vehicle 6.

In the traveling vehicle system 1 of the above embodiment, the branching roller 53 is engaged with the movable block 61 by switching the position of the branching roller 53 included in the traveling vehicle 6 in the left-right direction. In this configuration, an existing member included in the traveling vehicle 6 can be simply used without providing a new engagement part configured to be engaged with the movable block 61, and thus the traveling vehicle 6 can be manufactured at low cost.

In the traveling vehicle system 1 of the above embodiment, the moving mechanism 63 is supported by a lower support portion 43 attached to the working track 41. Thus, in comparison with a configuration in which a support member supporting the moving mechanism 63 is suspended individually from a ceiling or the like, man-hours required for installation can be significantly reduced.

The traveling vehicle 6 of the traveling vehicle system 1 of the above embodiment is an overhead traveling vehicle configured to travel along the traveling track 4, and the working track 41 is suspended from a trestle installed on the ceiling of a building or on the floor. With this configuration, the traveling vehicle 6 that a worker working while standing on the floor of the building cannot access can be moved. This is highly effective because it can save time and effort for the worker to prepare a stepladder or the like when manually moving the traveling vehicle 6.

In the traveling vehicle system 1 of the above embodiment, the traveling vehicle 6 can be moved even if the magnetic plate 40F is not provided in the working track 41. Consequently, in the working track 41, the top surface portion 40D on which the magnetic plate 40F is provided in the traveling track 4 can be made open, and thus maintenance on an upper portion of the traveling unit 50 can be performed easily.

Although an embodiment has been described above, an aspect of the present invention is not limited to the above-described embodiment. Various modifications can be made without departing from the gist of the invention.

In the above embodiment, an example has been described in which the branching roller 53 is used as an example of the engagement part. However, for example, a dedicated engagement member capable of being engaged with the movable block 61 may be provided to the traveling vehicle 6. In this case, the engagement part may be configured to be movable in the left-right or up-down direction by a driver, and the driver may be configured to be controllable by the area controller 90. Even in this case, the same effects as in the above embodiment can be obtained.

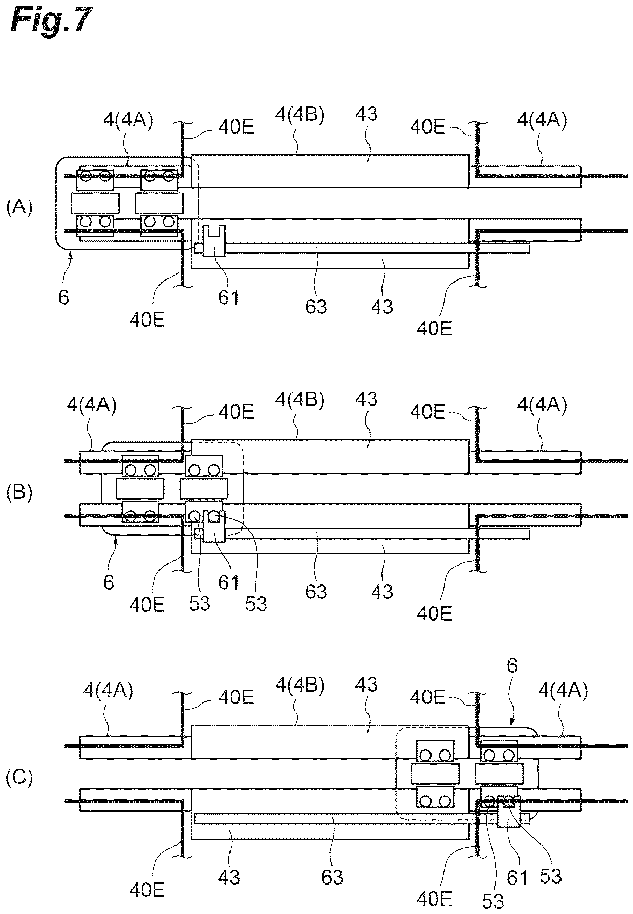

In the embodiment and the modifications above, an example has been described in which the power feeders 40E are provided along the extending direction in the working track 41. However, as illustrated in FIG. 7(A), the working track (non-self-propelling section) 41 may have a configuration in which the power feeders 40E are not provided. In this case, the traveling vehicle 6 cannot drive the shaft driver 63C configured to move the engagement part in the left-right direction because electricity is not supplied thereto in the working track 41. In view of this, as illustrated in FIG. 7(A), in the configuration of the traveling vehicle system 1 according to a modification, the moving mechanism 63 is set longer than the working track 41 in the traveling direction of the traveling vehicle 6 to be configured such that the movable block 61 with which the branching roller 53 in the front row is engaged extends to a position of the traveling track 4. In other words, in the configuration of this modification, as illustrated in FIG. 7(C), the moving mechanism 63 is configured so that the traveling vehicle 6 can be moved beyond the range of the working track 41 in the traveling direction of the traveling vehicle 6.

When the traveling vehicle 6 is moved beyond the range of the working track 41, as illustrated in FIG. 7(C), the body 50A that is one of the two bodies 50A and 50B of the traveling vehicle 6 overlaps the power feeders 40E of the traveling track 4, and thus the supply of electricity can be received and the position of the branching roller 53 can be switched in the left-right direction. In addition, the body 50A that is one of the two bodies 50A and 50B of the traveling vehicle 6 will overlap the magnetic plate 40F of the traveling track 4, and thus the traveling vehicle 6 can be self-propellable. Even with the configuration according to this modification, the traveling vehicle 6 can be moved on the working track 41 including no power feeders 40E. In addition, in the working track 41, the side surface portions 40C at which the power feeders 40E are provided in the traveling track 4 can be made open, and thus maintenance on side surface portions of the traveling unit 50 can be performed easily.

The working track 41 of the above embodiment has been described with an example in which the sides of the traveling vehicle 6 are completely open. However, it may have walls (side portions) in which a hole, into which the movable block 61 can be inserted, is formed. Even in this case, the movable block 61 can be moved in the extending direction of the working track 41 with the branching roller 53 engaged, and thus the traveling vehicle can be moved.

In the embodiment and the modifications above, an example has been described in which the working area 160 (i.e., the working track 41) is disposed between the traveling track 4 and the traveling track 4. However, the working area 160 may be disposed at an end of the traveling track 4.

In the embodiment and the modifications above, an example has been described in which the present invention is applied to the traveling track 4 for allowing the traveling vehicle 6 to travel in a suspended manner. However, the aspect of the present invention may be applied to a traveling vehicle system in which a traveling vehicle travels in a traveling track disposed on the floor.

The technical subject matter of the aspect of the present invention may be described as follows.
[1] A traveling vehicle system comprising:
   a traveling track forming a self-propelling section where a traveling vehicle is self-propellable;
   a working track forming a non-self-propelling section where the traveling vehicle is not self-propellable;
   a traveling vehicle configured to travel along the traveling track; and
   a moving unit configured to move the traveling vehicle in one direction in the non-self-propelling section, wherein
   the moving unit includes a moving mechanism configured to move a movable block in the one direction,
   the traveling vehicle includes
      one or more engagement parts capable of being engaged with the movable block, and
      a switching mechanism configured to switch a position of the engagement part between a first position at which the engagement parts are engaged with the movable block and a second position at which the engagement parts are separated from the movable block, wherein
   the moving mechanism moves the traveling vehicle by moving the movable block in the one direction with the engagement parts engaged.
[2] The traveling vehicle system according to [1], wherein the moving mechanism is a linear motion mechanism including a screw shaft and a driver.
[3] The traveling vehicle system according to [2], wherein
   the engagement parts are arranged in two or more rows in the one direction at an interval equal to or shorter than a maximum movement distance of the movable block in the linear motion mechanism, and
   the moving mechanism engages one of the engagement parts with the movable block to move the traveling vehicle in the one direction and then engages another of the engagement parts disposed downstream of the one of the engagement parts in the one direction with the movable block to move the traveling vehicle in the one direction.
[4] The traveling vehicle system according to any one of [1] to [3], wherein
   the traveling track includes:
      a branching section; and
      a plurality of guides configured to guide the traveling vehicle in respective directions branching at the branching section, and
   the engagement parts are branching rollers configured to switch the traveling direction of the traveling vehicle at the branching section by selectively coming into contact with each of the guides at the branching section.
[5] The traveling vehicle system according to any one of [1] to [4], wherein the moving mechanism is supported by a support member attached to the working track.
[6] The traveling vehicle system according to any one of [1] to [5], wherein
   the working track is suspended from a trestle installed on a ceiling or a floor of a building, and
   the traveling vehicle is an overhead traveling vehicle configured to transport an article by traveling along the working track.
[7] The traveling vehicle system according to any one of [1] to [6], wherein
   the traveling vehicle includes a linear motor configured to travel by magnetic force generated between the linear motor and a magnetic plate provided in the traveling track, and
   the magnetic plate is not provided in the working track.
[8] The traveling vehicle system according to any one of [1] to [7], wherein
   a power feeder configured to supply electricity to the traveling vehicle is disposed in the traveling track, and
   the power feeder is not provided in the working track.

### Reference Signs List

1 ... traveling vehicle system
4 ... traveling track
6 ... overhead traveling vehicle (traveling vehicle)
35 ... traveling vehicle controller
40E ... power feeder
40F ... magnetic plate
41 ... working track
42 ... frame
43 ... lower support portion
45 ... side support portion
50 ... traveling unit
50A, 50B ... body
51 ... traveling roller
53 ... branching roller
53A ... support member
53B ... roller driver
53C ... switching mechanism
57 ... power feed core
60 ... moving unit
61 ... movable block
63 ... moving mechanism
63A ... screw shaft
63B ... nut
63C ... shaft driver
63D ... slide rail
90 ... area controller
160 ... working area

## Claims

1. A traveling vehicle system comprising:
a traveling track forming a self-propelling section where a traveling vehicle is self-propellable;
a working track forming a non-self-propelling section where the traveling vehicle is not self-propellable;
a traveling vehicle configured to travel along the traveling track; and
a moving unit configured to move the traveling vehicle in one direction in the non-self-propelling section, wherein
the moving unit includes a moving mechanism configured to move a movable block in the one direction,
the traveling vehicle includes
one or more engagement parts capable of being engaged with the movable block, and
a switching mechanism configured to switch a position of the engagement parts between a first position at which the engagement parts are engaged with the movable block and a second position at which the engagement parts are separated from the movable block, wherein
the moving mechanism moves the traveling vehicle by moving the movable block in the one direction with the engagement parts engaged.

2. The traveling vehicle system according to claim 1, wherein the moving mechanism is a linear motion mechanism including a screw shaft and a driver.

3. The traveling vehicle system according to claim 2, wherein
the engagement parts are arranged in two or more rows in the one direction at an interval equal to or shorter than a maximum movement distance of the movable block in the linear motion mechanism, and
the moving mechanism engages one of the engagement parts with the movable block to move the traveling vehicle in the one direction and then engages another of the engagement parts disposed downstream of the one of the engagement parts in the one direction with the movable block to move the traveling vehicle in the one direction.

4. The traveling vehicle system according to claim 1 or 2, wherein
the traveling track includes:
a branching section; and
a plurality of guides configured to guide the traveling vehicle in respective directions branching at the branching section, and
the engagement parts are branching rollers configured to switch the traveling direction of the traveling vehicle at the branching section by selectively coming into contact with each of the guides at the branching section.

5. The traveling vehicle system according to claim 1 or 2, wherein the moving mechanism is supported by a support member attached to the working track.

6. The traveling vehicle system according to claim 1 or 2, wherein
the working track is suspended from a trestle installed on a ceiling or a floor of a building, and
the traveling vehicle is an overhead traveling vehicle configured to transport an article by traveling along the working track.

7. The traveling vehicle system according to claim 1 or 2, wherein
the traveling vehicle includes a linear motor configured to travel by magnetic force generated between the linear motor and a magnetic plate provided in the traveling track, and
the magnetic plate is not provided in the working track.

8. The traveling vehicle system according to claim 1 or 2, wherein
a power feeder configured to supply electricity to the traveling vehicle is disposed in the traveling track, and
the power feeder is not provided in the working track.
